Europäisches Patentamt

European Patent Office

Office européen des brevets

(11) Publication number: **0 296 508 B1**

## EUROPEAN PATENT SPECIFICATION

(45) Date of publication of patent specification: **04.03.92** (51) Int. Cl.5: **H03K 19/017**

(21) Application number: **88109727.3**

(22) Date of filing: **18.06.88**

(54) FET capacitance driver logic circuit.

(30) Priority: **23.06.87 US 65479**

(43) Date of publication of application:
**28.12.88 Bulletin 88/52**

(45) Publication of the grant of the patent:
**04.03.92 Bulletin 92/10**

(84) Designated Contracting States:
**DE FR GB**

(56) References cited:
**EP-A- 0 177 338**
**FR-A- 2 296 307**
**US-T- 955 006**

**PATENT ABSTRACTS OF JAPAN, vol. 4, no. 1
(E-163), 8th January 1980, page 115 E 163 &
JP-A-54 142 060 (MITSUBISHI DENKI K.K.)
11-05-1979**

**IBM TECHNICAL DISCLOSURE BULLETIN, vol.
18, no. 9, February 1976, pages 2960-2961,
New York, US; H.C. CHANG: "An enhanced
push-pull nor"**

(73) Proprietor: **HONEYWELL INC.**
**Honeywell Plaza**
**Minneapolis MN 55408(US)**

(72) Inventor: **Fulkerson, David E.**
**16500 Eagle Ridge Drive**
**Minnetonka Minnesota 55345(US)**

(74) Representative: **Rentzsch, Heinz et al**
**Honeywell Europe S.A. Holding KG Patent &
License Dept. Postfach 10 08 65 Kaiser-
leistrasse 39**
**W-6050 Offenbach am Main(DE)**

## Description

The invention is directed to logic design improvements, particularly to the problem of reducing gate delay due to capacitance.

In the related prior art there have been logic circuit types or families known as Si CMOS ("Complementary Metal Oxide Semiconductor"), GaAs DCFL ("Direct Coupled FET Logic") and GaAs super buffer; an example of a typical prior Si CMOS being shown schematically in Figure 1, an example of a typical GaAs DCFL being shown schematically in Figure 2 and an example of a typical prior art GaAs super buffer being shown in Figure 3.

FR-A-22 96 307 corresponding to U.S. Defense Publication T955006 describes Negative Resistance CMOS Circuits comprising the features as listed in the pre-characterizing portion of claim 1. A pair of complementary MOS-FET's are connected in series between a voltage supply and ground. A first FET has its gate tied to an input node and is biased off when the voltage at this node is Zero. A second FET is connected via its source-drain path between said input node and the supply voltage. One of the source-drain terminals of the first FET is connected to the gate of the second FET and both FET's are turned off initially. When the input voltage rises towards the threshold of the first FET, there is no current flow into or out of this negative resistance circuit. However, when the input voltage reaches said threshold, the first FET conducts thereby providing a gate voltage which turns on the second FET. This FET now conducts current from the supply voltage source into the input node. An increase in voltage from just below the threshold to just above this threshold causes current to flow out of the circuit. This circuit comprising complementary FET's provides a delay for either positive going transitions at the input node or for negative going transitions.

Furthermore, the IBM Technical Disclosure Bulletin, vol. 18, No. 9, February 1976, describes on pages 2960/61 a push-pull NOR gate with a relatively high speed comprising complementary FET's.

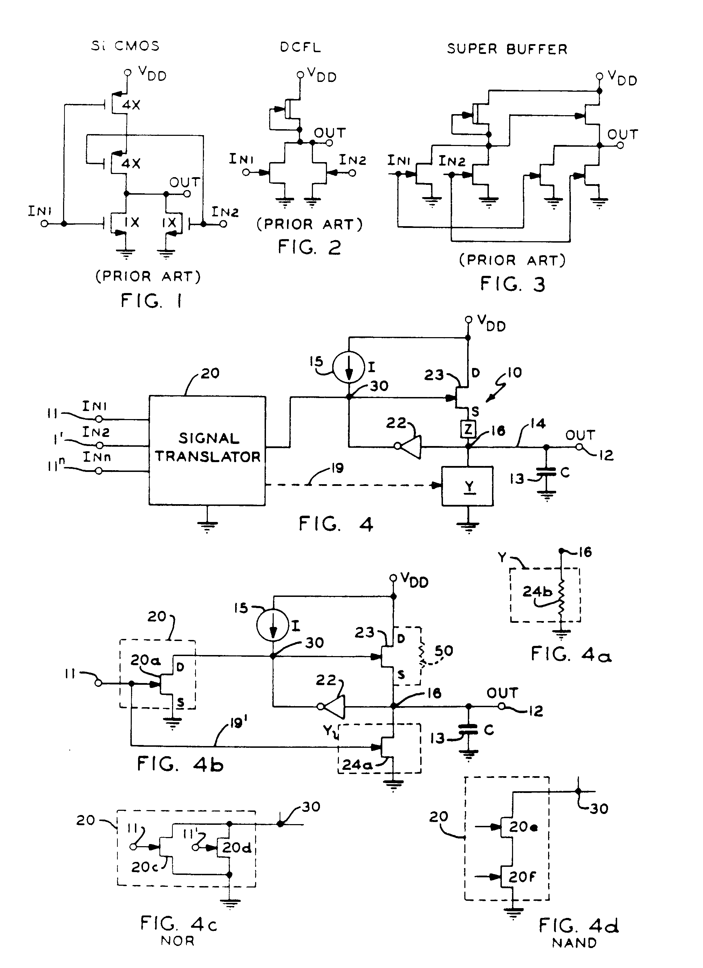

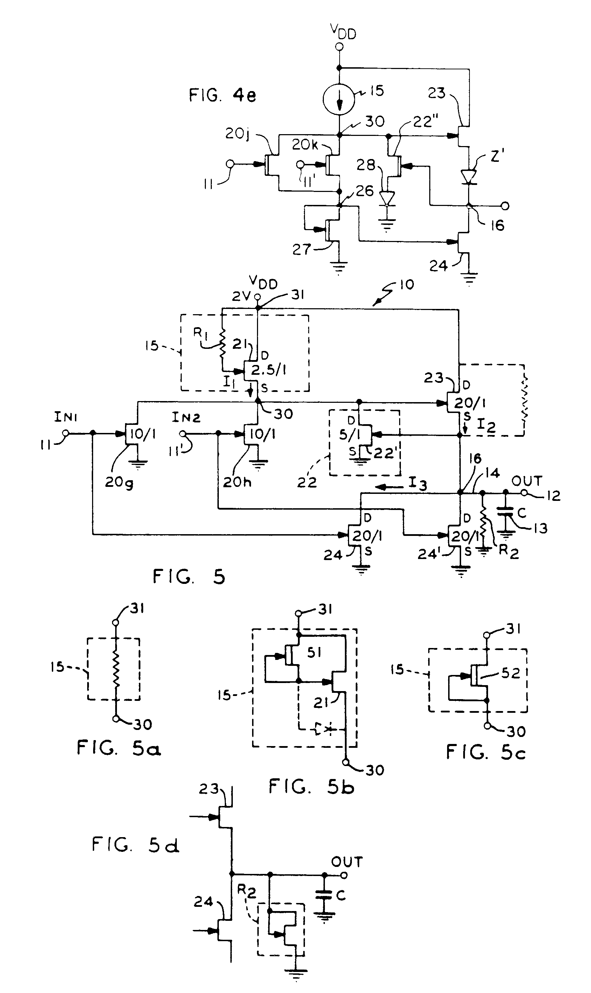

The present invention relates to a FET capacitance driver logic circuit subject to a capacitive load at the logic circuit output terminal, which capacitance tends to delay - switching at the output terminal. It is the object of the present invention to eliminate or at least to reduce the influence of the distributed output capacitance on the switching speed and performance of such FET driver logic circuits. This is accomplished by the invention as characterized in claim 1. The conceptual diagram of such a circuit is shown in Figure 4 with specific circuit arrangements being shown in the subsequent figures. Preferred details of the invention are described in the dependent claims.

Some of the advantages of the present invention over the previously known circuits include:

o the new circuit is faster than Si MOS or GaAs DCFL

o it has a higher noise margin than GaAs DCFL

o the power is lower than in a super- buffer

o this circuit drives high capacitance much faster and at lower power than DCFL or other circuits that don't turn off after the output transition (i.e., the capacitance charging current is relatively large and this current nearly turns off after output is "high", thus saving power)

o unlike CMOS, only one type of transistor (enhancement mode) is needed for some embodiments of the invention.

## BRIEF DESCRIPTION OF THE DRAWINGS

Figures 1, 2 and 3
are schematic circuit representations of related prior art circuits.
Figure 4
is a generalized circuit diagram showing the invention and
Figures 4a, 4b, 4c, 4d and 4e
are variations of Figure 4.
Figure 5
is a circuit schematic of a specific embodiment according to the invention.
Figures 5a, 5b and 5c
are variations of a first portion of Figure 5 and
Figure 5d is a variation of a second portion of Figure 5.
Figure 6
is a graphical presentation of several waveforms in the operating circuit.

## DESCRIPTION

Referring now generally to Figure 4 there is shown a simplified schematic of a FET logic circuit 10 having one or more input terminals 11, $11'$,...11n and an output terminal 12. Specifically it is intended as an improved capacitance driver logic circuit with Si, GaAs, or other semiconductor FET's. In the high speed Si and GaAs VLSI technologies (e.g.0.2mW, 150°C, $1\mu$ geometries) the interconnects 14 between logic stages and other logic stages connected to the output each inherently present a troublesome parasitic capacitance 13 to the circuit 10, the magnitude of which may be in the order of $200 \times 10^{-15}$ farads, for example. The capacitance 13 is responsible for gate delays thus limiting the response time of the overall logic system. Referring again to Figure 4, a voltage source $V_{DD}$ is connected through the drain-source circuit of a FET 23, a junction 16, and an output interconnect 14 to the output 12. The parasitic capacitance 13 exists between output 12 and ground. The transistor 23 operates as a "pull-up" device for output 12. The junction 16 is also connected through a voltage pull-down circuit Y to a voltage reference or ground. The circuit Y may take several forms, passive or active as will be described later. The circuit Z could be an impedance or voltage shift circuit or a short circuit. A current means (resistor, transistor, etc.) 15 supplies current to a junction 30 which is connected to the gate electrode of FET 23. A signal translator 20, which may take several forms, interconnects the signal input 11 in controlling relation with the gate electrode of FET 23. A most important additional feature of the circuit is an inverter means 22 coupled from junction 16 to the gate of FET 23. A dashed line 19 interconnects signal translator 20 to the pull-down circuit Y when Y is an active device.

The purpose of this invention is to minimize the delay effect of the capacitance 13 while maintaining a low power level. This is accomplished by allowing FET 23 to rapidly charge C and then to essentially turn off 23 after the output is high. In Figure 4a the pull-down means Y is shown as a passive resistor 24b connected between junction 16 and ground. In Figure 4b is shown another embodiment of Figure 4 in which the pull-down means Y is shown as a FET 24a. FET 24a has its source-drain circuit connected between junction 16 and ground. Figure 4b also shows signal translator 20 in the form of a FET 20a in which the drain-source circuit is connected from junction 30 to ground. The FET 20a has its gate directly connected to input 11. Input 11 is also connected to the gate of FET 24a. The output circuits of FETs 23 and 24a are serially connected so that a circuit path can be traced from source $V_{DD}$ through FET 23 from drain to source, output junction 16, from drain to source of FET 24a, the source electrode being connected to a voltage reference or ground. In another variation a resistance 50 is connected in parallel with FET 23. The junction 16 is also connected to the input of inverter 22, the output of which is connected to the gate of FET 23.

In Figure 4c in another embodiment the signal translator 20 is shown in a NOR arrangement having a pair of inputs 11 and 11′ connected to the gate electrodes of FETs 20c and 20d. Figure 4d shows the signal translator 20 connected as a NAND arrangement in which FETs 20e and 20f are connected in series between junction 30 and ground. Figure 4e shows another embodiment of a NOR logic gate. A pair of inputs 11 and 11′ are connected to the gate electrodes of depletion mode FET's 20j and 20k. The drain electrodes are connected to terminal 30 and the source electrodes are connected to ground through a junction 26 and a depletion mode FET 27 connected to provide an impedance to junction 26. The junction 26 is connected to the gate electrode of FET 24. When one of the input transistors is conducting, the voltage developed at junction 26 is effective to turn on pull-down FET 24. In this embodiment the impedance element Z between FET 23 and junction 16 is shown in the form of a diode Z′. Also the inverter 22 is shown as a depletion mode FET 22″ and diode 28. The diode 28 connects the FET 22″ to ground.

A specific embodiment of the general circuit of Figure 4 is shown in Figure 5. The same numbering is used in both figures where applicable. Referring now to Figure 5 there is disclosed a logic circuit having two input terminals 11 and 11′, and an output terminal 12. The circuit includes a number of enhancement type GaAs FETs 20g, 20h, 21, 22′, 23, 24 and 24′. Input 11 is connected to the gate of FETs 20g and 24. Input 11′ is connected to the gate of FETs 20h and 24′. The source electrode of FETs 20g, 20h, 22′, 24 and 24′ is connected to ground. The drain electrodes of FETs 20g and 20h are connected to a lower terminal 30 of current means 15. In this embodiment the current means 15 is shown in the form of enhancement type FET 21, the source electrode of which is connected to terminal 30 and the drain electrode of which is connected by junction 31 to a voltage supply $V_{DD}$, which voltage may be 2 volts, for example. The gate electrode of FET 21 is connected to the drain electrode through a biasing resistor $R_1$. $R_1$ may have a resistance on the order of 100K ohms, for example. The current means provides a current $I_1$ at terminal 30. The current means 15 may take other forms such as is shown in Figure 5a, 5b or 5c.

A circuit path can also be traced from the voltage supply terminal 31 through FET 23 output circuit from drain to source, junction 16 (and thus by interconnect 14 to output 12), and a resistor $R_2$ to ground. Resistor $R_2$ may have a resistance on the order of 100K ohms, for example. In parallel with resistor $R_2$ is the capacitance 13, previously discussed. Also in parallel with resistor $R_2$ is the output circuit of FET 24 and also the output circuit of FET 24′. Thus a circuit path can be traced from junction 16 to the drain electrode of both FETs 24 and 24′, their source electrodes being grounded as previously mentioned. The inverter 22 is an enhancement FET 22′ having its gate connected to junction 16, its drain connected to the gate of FET 23 and its source electrode grounded. The resistor $R_2$ may take on alternate form such as the transistor shown in Figure 5d.

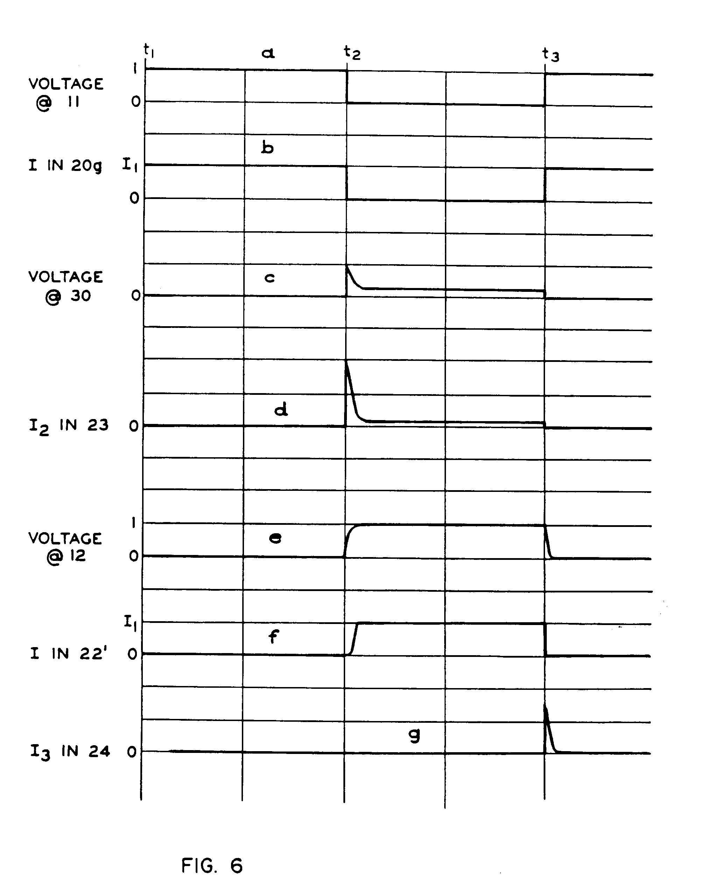

The logic circuit 10 of Figure 5 operates substantially as follows. (Please refer to Figure 6 for waveforms.) The transistor 21 forms a current means, with current $I_1$ at terminal 30 given approximately by

$$I_1 = K' (V_D - V_T)^2 + I_{R1}$$

where $V_D$ is the gate-to-source diode voltage, $V_T$ is the threshold voltage, $K'$ is the gain and $I_{R1}$ is the current through biasing resistor R1. The above-mentioned gate-to-source diode is inherent in GaAs FETs.

Assume input 11' is low (0) and FETs 20h and 24' are off throughout this explanation. Assume input 11 is high (1) and FETs 20g and 24 are on (time $t_1$). With FET 20g conducting it is effective to sink all of the current $I_1$ so that the voltage at 30 is low. FET 23 is thus not conducting and $I_2$ is zero or nearly zero, thus "on" transistor 24 has to sink virtually no current subsequent to initially discharging capacitance 13. The output at 12 is low.

Assume input 11 goes low (0), and as FETs 20g and 24 are turning off the FET 23 turns on full (time $t_2$). The low impedance output circuit of FET 23 allows a high current to flow initially while charging the capacitance 13 as the output 12 is going high. During the initial time period as FET 23 turns on the FET 22' is off. As long as the output voltage is lower than the threshold voltage necessary to turn FET 22' on, the FET 23 is free to provide as much current into capacitance 13 as it is capable of delivering. As the charging continues and the output voltage rises to the threshold, the FET 22' becomes conductive and sinks the current $I_1$. The output voltage at 12 (or 16) will only be allowed to rise high enough to allow FET 22' to sink essentially all of the current $I_1$. At this point the gate bias at FET 23 reduces the current $I_2$ through the FET to near zero to supply only enough d.c. current to drive the resistance $R_2$ and the small gate current required by FET 22' and the output loads. Assume input 11 now goes high (time $t_3$) and FETs 20 and 24 turn on. Conductive FET 20g again sinks the current $I_1$, the voltage at 30 is low, FET 23 turns off, $I_2$ goes to zero, current pulse $I_3$ flows through FET 24 to discharge capacitance 13 and output 12 is low.

In Figure 6 the curves a-g show the approximate waveforms of voltage and current at various points of the circuit as described above. Curve a is the voltage at signal input terminal 11. Curve b is the waveform of current flowing through FET 20g. Curve c is a voltage waveform of the voltage at terminal 30 and the gate of FET 23. Curve d is a current waveform of the current $I_2$ flowing through FET 23. Curve e is a voltage waveform at output terminal 12. Curve f is a current waveform of the current flowing through FET 22'. Curve g is a current waveform of current flowing through FET 24.

The FETs 20, 20', 22', 21, 23, 24 and 24' have been previously described as being enhancement type FETs; however, as shown in Figure 5 they need not all be exactly identical in size. FET 21 is shown as having channel width/length dimensions in microns of 2.5/1; FETs 20 and 20' having dimensions of 10/1; FETs 24, 24' and 23 having dimensions of 20/1; and FET 22' having dimensions of 5/1. These various FETs can be modified as desired.

With this integrated circuit the current means 15 may take other forms than that shown in Figure 5 and several typical variations are shown in Figures 5a, 5b and 5c. In Figure 5a a resistance is shown; in Figure 5b a depletion mode FET 51 provides the bias current for the FET 21; and in Figure 5c a depletion mode FET 52 is shown. Also the resistance R2 shown in Figure 5 may take other forms and one such modification is shown in Figure 5d.

The inverter means 22 has been several times recited as being coupled or connected from junction 16 to the gate of FET 23, so that the initially full on FET 23 (at time $t_2$) can be cut back by inverter means 22 as soon as the output voltage (at 12 and 16) reaches the desired level, in this case the threshold voltage of FET 22'. The important function is that the signal of the inverter means is coupled to cut back the conduction of FET 23 and this coupling may include a more indirect circuit route as well as the direct connection to the gate which is shown.

## Claims

1. A FET logic circuit comprising:

   a) a first FET (23) having its output electrodes interconnecting a source of voltage ($V_{DD}$) and a logic output terminal (12, 16);

   b) a second FET (24, 24A) having its output electrodes interconnecting said output terminal (12, 16) and a voltage reference (ground);

   c) a current means (15) having an output terminal (30) connected to the gate electrode of said first FET (23);

   d) a third FET (20) having its output electrodes interconnecting said current means output terminal (30) and said reference voltage, said third FET (20) having its gate electrode adapted to be connected to a signal source (11) for controlling the conductivity of said third FET,

   **characterized in that**

   e) both the first and second FETs (23, 24, 24A) are of the same type, and

f) an inverter (22) is connected in a negative feedback loop from the logic output terminal (12, 16) to the gate electrode of said first FET (23).

2. The circuit of claim 1, **characterized in that**
a) said inverter (22) includes a fourth FET (22') of the same type as the first and second FETs (23, 24, 24A);
b) the output electrodes of said fourth FET (22') interconnect said gate electrode of the first FET (23) and said voltage reference; and
c) the gate electrode of said fourth FET (22') is connected to said logic output terminal (12, 16).

3. The circuit of claim 2, **characterized by** a diode (28) connected between the reference voltage and said fourth FET (22'').

4. The circuit according to one of the claims 1 to 3, **characterized by** a resistor (R2) connected between said logic circuit output (12, 16) and said reference voltage.

5. The circuit of claim 4, **characterized in that** said resistor (R2) has a value in the order of 100k Ohms.

6. The circuit according to one of the preceding claims, **characterized in that** said current means (15) comprises a fifth FET (21) having its output electrodes connected between said voltage source ($V_{DD}$) and said current means output terminal (30).

7. The circuit according to one of the claims 2 to 7, **characterized in that**
a) said first FET (23) when conductive operates as a voltage pull-up circuit for said logic output terminal (12, 16);
b) said second FET (24, 24A) operates as a voltage pull-down circuit interconnecting said output terminal (12, 16) and said voltage reference; and
c) said fourth FET (22, 22', 22'') having its output coupled to said first FET (23) gate electrode constitutes an output voltage sensor having a sensed voltage threshold at which said sensor couples to said first FET gate electrode a signal to limit the pull-up to said threshold level.

8. The circuit according to one of the preceding claims, **characterized in that** all FETs are enhancement type GaAs FETs.

9. The circuit according to one of the preceding claims with each FET having a source electrode, a drain electrode and a gate electrode, **characterized in that**
a) the first FET (23) drain electrode is connected to said voltage source ($V_{DD}$);
b) said first FET (23) source electrode is connected to the logic circuit output terminal (12, 16) and to the drain electrode of said second FET (24);
c) the source electrode of said second FET (24, 24A) is connected to the reference voltage;
d) the fourth FET (22, 22') has its gate electrode connected to said first FET (23) source electrode, its drain electrode connected to said first FET gate electrode and its source electrode connected to said reference voltage;
e) the third FET (20) has its gate electrode connected to a signal input terminal (11) and to the gate electrode of said second FET (24, 24A), its source electrode connected to said reference voltage and its drain electrode connected to said current means (15).

10. The circuit according to one of the claims 2 to 10, **characterized in that**
a) said first FET (23) and said second FET (24, 24a) have a channel width/length dimension in microns on the order of 20/1;
b) said third FET (20) has a channel width/length dimension in microns on the order of 10/1; and
c) said fourth FET (22, 22', 22'') has a channel width/length dimension in microns on the order of 5/1.

11. The circuit according to one of the preceding claims, **characterized in that** said distributed capacitance has a value on the order of $200 \times 10^{-15}$ Farads.

**Revendications**

1. Circuit logique à transistors FET comprenant :
a) un premier transistor FET (23) dont les électrodes de sortie raccordent une source de tension ($V_{DD}$) et une borne de sortie logique (12,16);
b) un second transistor FET (24,24A) dont les électrodes de sortie raccordent ladite borne de sortie (12,16) à une tension de référence (masse);
c) des moyens d'alimentation en courant (15) possédant une borne de sortie (30) raccordée à l'électrode de grille dudit premier transistor FET (23);

d) un troisième transistor FET (20) dont les électrodes de sortie raccordent la borne de sortie (30) desdits moyens d'alimentation en courant et ladite tension de référence, l'électrode de grille dudit troisième transistor FET (20) étant adaptée pour être raccordée à une source de signal (11) pour commander la conductivité dudit troisième transistor FET,

caractérisé en ce que

e) les premier et second transistors FET (23,24,24A) sont tous deux du même type, et

f) un inverseur (22) est raccordé dans une boucle de contre-réaction depuis la borne de sortie logique (12,16) à l'électrode de grille dudit premier transistor FET (23).

**2.** Circuit selon la revendication 1, caractérisé en ce que

a) ledit inverseur (22) comprend un quatrième transistor FET (22') du même type que les premier et second transistors FET (23,24,24A);

b) les électrodes de sortie dudit quatrième transistor FET (22') raccordent ladite électrode de grille dudit premier transistor FET (23) et ladite tension de référence, et

c) l'électrode de grille dudit quatrième transistor FET (22') est raccordée à ladite borne de sortie logique (12,16).

**3.** Circuit selon la revendication 2, caractérisé par une diode (28) branchée entre la tension de référence et ledit quatrième transistor FET (22").

**4.** Circuit selon l'une des revendications 1 à 3, caractérisé par une résistance (R2) branchée entre ladite sortie de circuit logique (12,16) et ladite tension de référence.

**5.** Circuit selon la revendication 4, caractérisé en ce que ladite résistance (R2) possède une valeur de 100 k.ohms.

**6.** Circuit selon l'une des revendications précédentes, caractérisé en ce que lesdits moyens d'alimentation en courant (15) comprennent un cinquième transistor FET (21) dont les électrodes de sortie sont raccordées entre ladite source de tension ($V_{DD}$) et ladite borne de sortie (3) des moyens d'alimentation en courant.

**7.** Circuit selon l'une des revendications 2 à 7, caractérisé en ce que

a) ledit premier transistor FET (23) agissant, lorsqu'il est conducteur, en tant que circuit d'accroissement de tension pour ladite borne de sortie logique (12,16);

b) ledit second transistor FET (24,24A) agit, en tant que circuit abaisseur de tension raccordant ladite borne de sortie (12,16) et ladite tension de référence; et

c) ledit quatrième transistor FET (22,22',22"), dont la sortie est couplée à ladite électrode de grille du premier transistor FET (23), constitue un capteur de la tension de sortie qui possède un seuil de la tension détectée, pour lequel ledit capteur couple à ladite électrode de grille du premier transistor FET un signal pour limiter l'accroissement dudit niveau de seuil.

**8.** Circuit selon l'une des revendications précédentes, caractérisé en ce que tous les transistors FET sont des transistors FET au GaAs du type à enrichissement.

**9.** Circuit selon l'une des revendications précédentes, dans lequel chaque transistor FET possède une électrode de source, une électrode de drain et une électrode de grille, caractérisé en ce que

a) l'électrode de drain du premier transistor FET (23) est raccordée à ladite source de tension ($V_{DD}$);

b) ladite électrode de source du premier transistor FET (23) est raccordée à la borne de sortie (12,16) du circuit logique et à l'électrode de drain dudit second transistor FET (24);

c) l'électrode de source dudit second transistor FET (24, 24A) est raccordée à la tension de référence;

d) l'électrode de grille du quatrième transistor FET (22, 22') est raccordée à ladite électrode de source du premier transistor FET (23), son électrode de drain est raccordée à l'électrode de grille du premier transistor FET et son électrode de source est raccordée à ladite tension de référence;

e) l'électrode de grille du troisième transistor FET (21) est raccordée à une borne (11) d'entrée de signal et à l'électrode de grille dudit second transistor FET (24, 24A), son électrode de source est raccordée à ladite tension de référence et son électrode de drain est raccordée auxdits moyens d'alimentation en courant (15).

**10.** Circuit selon l'une des revendications 2 à 10, caractérisé en ce que

a) dans ledit premier transistor FET (23) et ledit second transistor FET (24,24a), le rapport des dimensions largeur/longueur du canal en microns est de l'ordre de 20/1;
b) dans ledit troisième transistor FET (20) le rapport des dimensions largeur/longueur du canal en microns est de l'ordre de 10/1; et
c) dans ledit quatrième transistor FET (22,22',22") le rapport des dimensions largeur/longueur du canal en microns est de l'ordre de 5/1.

11. Circuit selon l'une des revendications précédentes, caractérisé en ce que ladite capacité distribuée possède une valeur de l'ordre de $200 \times 10^{-15}$ farads.

**Patentansprüche**

1. Logikschaltung mit Feldeffektransistoren (FET) mit:
    a) einem ersten FET (23), dessen Ausgangselektroden eine Spannungsquelle ($V_{DD}$) mit einer logischen Ausgangsklemme (12, 16) verbinden;
    b) einem zweiten FET (24, 24A), dessen Ausgangselektroden die logische Ausgangsklemme (12, 16) mit einer Bezugsspannung (Masse) verbinden;
    c) einer Stromquelle (15), deren eine Ausgangsklemme (30) mit der Steuerelektrode des ersten FET (23) in Verbindung steht;
    d) einem dritten FET (20), dessen Ausgangselektroden die Ausgangsklemme (30) der Stromquelle mit der Bezugsspannung verbinden und dessen Steuerelektrode zur Steuerung der Leitfähigkeit des dritten FET an eine Signalquelle (11) anschließbar ist; **dadurch gekennzeichnet, daß**
    e) der erste und der zweite FET (23; 24, 24A) vom gleichen Typ sind, und
    f) ein Inverter (22) in eine negative Rückkopplungsschleife zwischen die logische Ausgangsklemme (12, 16) und die Steuerelektrode des ersten FET (23) eingeschaltet ist.

2. Schaltungsanordnung nach Anspruch 1, **dadurch gekennzeichnet,**
    a) daß der Inverter (22) einen vierten FET (22') vom gleichen Typ wie der erste und zweite FET (23; 24, 24A) enthält;
    b) die Ausgangselektroden des vierten FET (22') die Steuerelektrode des ersten FET (23) mit der Bezugsspannung verbinden; und
    c) die Steuerelektrode des vierten FET (22') an die logische Ausgangsklemme (12, 16) angeschlossen ist.

3. Schaltungsanordnung nach Anspruch 2, **gekennzeichnet durch** eine zwischen die Bezugsspannung und den vierten FET (22") eingeschaltete Diode (28).

4. Schaltungsanordnung nach einem der Ansprüche 1 bis 3, **gekennzeichnet durch** einen zwischen den logischen Schaltungsausgang (12, 16) und die Bezugsspannung eingeschalteten Widerstand (R2).

5. Schaltungsanordnung nach Anspruch 4, **dadurch gekennzeichnet,** daß der Widerstand (R2) einen Widerstandswert in der Größenordnung von 100k Ohm hat.

6. Schaltungsanordnung nach einem der vorangehenden Ansprüche, **dadurch gekennzeichnet,** daß die Stromquelle (15) einen fünften FET (21) aufweist, dessen Ausgangselektroden zwischen die Spannungsquelle ($V_{DD}$) und die Ausgangsklemme (30) der Stromquelle eingeschaltet sind.

7. Schaltungsanordnung nach einem der Ansprüche 2 bis 7, **dadurch gekennzeichnet,** daß
    a) der erste FET (23) im leitenden Zustand als Spannungs-Pull-Up-Schaltung für die logische Ausgangsklemme (12, 16) arbeitet;
    b) der zweite FET (24, 24A) als Spannungs-Pull-Down-Schaltung die Ausgangsklemme (12, 16) mit der Bezugsspannung verbindet; und
    c) der vierte FET (22, 22', 22") mit seinem Ausgang an die Steuerelektrode des ersten FET (23) angeschlossen einen Fühler für die Ausgangsspannung bildet, mit einem Schwellwert für die gemessene Spannung, bei dem der Fühler ein Signal an die Steuerelektrode des ersten FET legt, um das Heraufziehen der Spannung auf den Schwellwert zu begrenzen.

8. Schaltungsanordnung nach einem der vorangehenden Ansprüche, **dadurch gekennzeichnet,** daß alle Feldeffekttransistoren GaAs-FETs vom Anreicherungstyp sind.

9. Schaltungsanordnung nach einem der vorangehenden Ansprüche, bei der jeder FET eine Quellenelektrode, eine Senkenelektrode sowie eine Steuerelektrode aufweist, **dadurch gekennzeichnet,** daß
    a) die Senkenelektrode des ersten FET (23) an die Spannungsquelle ($V_{DD}$) angeschlossen ist;
    b) die Quellenelektrode des ersten FET (23) an die logische Schaltungsausgangsklemme (12, 16) und an die Senkenelektrode des zweiten FET (24) angeschlossen ist;

c) die Quellenelektrode des zweiten FET (24, 24A) mit der Bezugsspannung verbunden ist;

d) der vierte FET (22, 22') mit seiner Steuerelektrode an die Quellenelektrode des ersten FET (23), mit seiner Senkenelektrode an die Steuerelektrode des ersten FET und mit seiner Quellenelektrode an die Bezugsspannung angeschlossen ist;

e) der dritte FET (20) mit seiner Steuerelektrode an die Signaleingangsklemme (11) und an die Steuerelektrode des zweiten FET (24, 24A) angeschlossen ist, mit seiner Quellenelektrode an die Bezugsspannung und mit seiner Senkenelektrode an die Stromquelle (15) angeschlossen ist.

10. Schaltungsanordnung nach einem der Ansprüche 2 bis 9, **dadurch gekennzeichnet,** daß

a) der erste FET (23) und der zweite FET (24, 24A) ein Kanalbreiten/Längenverhältnis in $\mu$m in der Größenordnung von 20/1 haben;

b) der dritte FET (20) ein Kanalbreiten/Längenverhältnis in $\mu$m in der Größenordnung von 10/1 hat; und

c) der vierte FET (22, 22', 22'') ein Kanalbreiten/Längenverhältnis in $\mu$m in der Größenordnung von 5/1 hat.

11. Schaltungsanordnung nach einem der vorangehenden Ansprüche, **dadurch gekennzeichnet,** daß die verteilte Kapazität einen Wert in der Größenordnung von $200 \times 10^{-15}$ Farad aufweist.

Si CMOS

(PRIOR ART)
FIG. 1

DCFL

(PRIOR ART)
FIG. 2

SUPER BUFFER

(PRIOR ART)
FIG. 3

FIG. 4

FIG. 4a

FIG. 4b

FIG. 4c
NOR

FIG. 4d
NAND

9

FIG. 4e

FIG. 5

FIG. 5a

FIG. 5b

FIG. 5c

FIG. 5d

FIG. 6